# FASCICULE DE BREVET EUROPEEN

(11) **EP 3 261 129 B1**
(45) Date de publication et mention de la délivrance du brevet: **06.05.2020**
(21) Numéro de dépôt: 17182781.9
(22) Date de dépôt: 24.11.2016
(51) Int. Cl.: H01L 29/861, H01L 27/08

(54) **STRUCTURE DE DIODE**
DIODENSTRUKTUR
DIODE STRUCTURE

(30) Priorité: 15.04.2016 FR 1653369; 15.04.2016 FR 1653371
(43) Date de publication de la demande: 27.12.2017
(62) Demande divisionnaire de: 16200596.1
(73) Titulaire: STMicroelectronics (Tours) SAS, 37100 Tours (FR)
(72) Inventeur: LANOIS, Frédéric, 37100 TOURS (FR); ANKOUDINOV, Alexei, REDWOOD, WA 98052 (US); RODOV, Vladimir, SEATTLE, WA 98146 (US)
(74) Mandataire: Cabinet Beaumont

(56) Documents cités:
- JP-A- S5 797 663
- US-A- 4 829 359
- US-A1- 2009 057 711
- US-B2- 9 029 921
- UMAMAHESWARA REDDY VEMULAPATI ET AL: "The Concept of a Regenerative Diode", POWER SEMICONDUCTOR DEVICES AND IC'S, 2007. ISPSD '07. 19TH INTERNATIONAL SYMPOSIUM ON, IEEE, PI, 1 mai 2007 (2007-05-01), pages 193-196, XP031129701, ISBN: 978-1-4244-1095-8

## Description

### Domaine

La présente demande concerne le domaine des composants semiconducteurs, et en particulier une diode, c'est-à-dire un composant électronique à deux électrodes ayant un sens direct de circulation d'un courant.

### Exposé de l'art antérieur

La figure 1 est une vue en coupe d'une diode et correspond à la figure 5 du brevet US 9029921. Cette diode est adaptée à présenter une très faible chute de tension en direct et à supporter des tensions importantes dans le sens inverse, par exemple de plusieurs dizaines de volts. Elle peut être utilisée par exemple dans un redresseur à diodes ou dans un convertisseur de puissance continu-continu tel qu'un hacheur série.

La diode 1 est formée dans et sur un substrat semiconducteur 3 faiblement dopé de type N (N-) situé entre une cathode K connectée à la face inférieure et une anode A.

La partie supérieure du substrat 3 contient un caisson 5 dopé de type P. Le caisson 5 comprend dans sa partie supérieure un caisson 6 plus fortement dopé de type N que le substrat. Une zone 7 séparée du caisson N 6 et plus fortement dopée de type P que le caisson 5 se trouve dans la partie supérieure du caisson 5. Une zone 12 plus fortement dopée de type N que le caisson 6 se trouve en partie supérieure du caisson P 5 à cheval sur le caisson N 6. Une grille 14 en silicium polycristallin dopé de type N (N-POLY) sur un isolant 16, recouvre une partie du caisson 5 située entre la zone 12 et le substrat, et se prolonge au-dessus du substrat. Une zone de source 22, dopée de type P et plus fortement dopée que le caisson 5, est située en partie supérieure du caisson 6 et en contact avec la zone 12. Une grille 24 en silicium polycristallin dopé de type P (P-POLY) s'étend sur un isolant 26 entre les zones 7 et 22 et recouvre ainsi une partie du caisson N 6.

On a obtenu ainsi un transistor MOS vertical T1 à canal N dont la source correspond à la zone 12, le drain à une partie 27 du substrat, et la région de formation de canal à une partie supérieure 28 du caisson 5. La grille 14 du transistor T1 recouvre la région de formation de canal et la partie 27 du substrat.

On a également formé un transistor MOS à canal P T2 dont la source correspond à la zone 22, le drain au caisson 5 et la région de formation de canal à une partie 29 du caisson 6.

Les zones de source 12 et 22 des transistors T1 et T2 sont connectées entre elles. La grille 14 du transistor T1 et la zone de drain 5 du transistor T2 sont reliées à l'anode A de la diode. Les transistors T1 et T2 sont connectés en série entre la cathode K et l'anode A, la grille 14 du transistor T1 étant connectée à l'anode. Les deux transistors ainsi connectés constituent une structure de conduction 35.

Une zone 37 s'étend dans la partie supérieure du substrat 3 à partir de la partie 27 du substrat en s'éloignant de la grille 14 du transistor T1. La zone 37 est couplée à la grille 24 du transistor T2 et constitue une structure de commande.

Lorsque la tension entre anode et cathode est positive, les transistors T1 et T2 sont passants. Lorsque la tension entre anode et cathode est négative, les grilles sont portées à des potentiels qui bloquent les transistors.

Le brevet susmentionné indique que les isolants 16 et 26 doivent être minces sous les grilles 14 et 24 pour que la diode puisse conduire un courant à des tensions directes faibles, et que la structure de commande 37 fournit à la grille 24 un potentiel adapté ; en effet, l'application directe sur cette grille d'une forte tension inverse pourrait endommager l'isolant 26.

Cependant, les diodes ci-dessus présentent divers problèmes de performances. On souhaite disposer de diodes de performances améliorées.

### Résumé

On prévoit de modifier, d'une part, la structure de conduction, d'autre part, la structure de commande d'une diode telle que décrite ci-dessus.

Ainsi, un exemple utile à la compréhension de l'invention prévoit une diode comprenant entre une électrode supérieure et une électrode inférieure : des première et deuxième portions de substrat semiconducteur d'un premier type de conductivité connectées à l'électrode inférieure ; un premier transistor vertical et un deuxième transistor formés dans la première portion et connectés en série entre les électrodes, la grille du premier transistor étant dopée du premier type de conductivité et couplée à l'électrode supérieure, le deuxième transistor étant à canal d'un deuxième type de conductivité et ayant une grille dopée du deuxième type de conductivité ; et des première et deuxième zones dopées du deuxième type de conductivité situées dans la deuxième portion et séparées par une partie de substrat surmontée d'une autre grille dopée du premier type de conductivité, la première zone dopée servant de sonde de potentiel et étant couplée à la grille du deuxième transistor, la deuxième zone dopée et ladite autre grille étant couplées à l'électrode supérieure.

Selon un exemple utile à la compréhension de l'invention: le premier transistor comprend une zone de source située dans un premier caisson dopé du deuxième type de conductivité, une partie supérieure du premier caisson étant une région de formation de canal du premier transistor ; et le deuxième transistor comprend une zone de source située dans un deuxième caisson dopé du premier type de conductivité situé dans le premier caisson, une partie supérieure du deuxième caisson étant une région de formation de canal du deuxième transistor.

Selon un exemple utile à la compréhension de l'invention, le deuxième transistor a une grille recouvrant une partie du premier caisson.

Selon un exemple utile à la compréhension de l'invention, le premier transistor comprend une zone de source située dans un caisson dopé du deuxième type de conductivité, une partie supérieure du caisson étant une région de formation de canal du premier transistor ; et le deuxième transistor a une région de formation de canal située hors du caisson.

Selon un exemple utile à la compréhension de l'invention, chacune des grilles est associée à un isolant de grille d'épaisseur inférieure à 10 nm.

Selon un exemple utile à la compréhension de l'invention, la première zone dopée et le substrat de la deuxième portion forment une jonction PN.

Selon un exemple utile à la compréhension de l'invention, un troisième transistor couple la première zone dopée au substrat, le troisième transistor étant à fonctionnement sous le seuil à tension nulle.

Selon un exemple utile à la compréhension de l'invention, le troisième transistor a une grille commune avec ladite autre grille.

Selon un exemple utile à la compréhension de l'invention, ladite autre grille et la deuxième zone dopée entourent la première zone dopée.

Selon un exemple utile à la compréhension de l'invention, les première et deuxième portions sont des portions d'un même substrat semiconducteur.

Selon un exemple utile à la compréhension de l'invention, la diode comprend une pluralité de premières portions et une pluralité de deuxièmes portions, la grille du deuxième transistor de chaque première portion étant couplée à une première zone dopée d'une deuxième portion.

Un exemple utile à la compréhension de l'invention prévoit un pont redresseur à diodes comprenant la diode ci-dessus.

Un exemple utile à la compréhension de l'invention prévoit un convertisseur de puissance continu-continu comprenant la diode ci-dessus.

Un mode de réalisation de l'invention prévoit une diode selon la revendication 1.

Selon un mode de réalisation, chacune des grilles est associée à un isolant de grille d'épaisseur inférieure à 10 nm.

Selon un mode de réalisation, les premier et deuxième transistors sont à fonctionnement sous le seuil à tension nulle.

Selon un mode de réalisation, la région de formation de canal du premier transistor est dopée de 5*10¹⁶ à 5*10¹⁷ atomes/cm³.

Selon un mode de réalisation, la région de formation de canal du deuxième transistor est dopée de 10¹⁶ à 5*10¹⁷ atomes/cm³.

Un mode de réalisation prévoit un pont redresseur à diodes comprenant la diode ci-dessus.

Un mode de réalisation prévoit un convertisseur de puissance continu-continu comprenant la diode ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe d'une diode telle que décrite dans le brevet US 9029921 ;
la figure 2A est une courbe courant-tension ;
la figure 2B est une courbe tension-tension ;
la figure 3 est une vue schématique en coupe d'un exemple d'une diode utile à la compréhension de l'invention;
la figure 4 est une courbe illustrant la densité de courant dans deux diodes ;
la figure 5 est une vue partielle en coupe illustrant une variante de réalisation d'une diode ;
la figure 6 est une vue en coupe illustrant un mode de réalisation d'une diode selon la présente invention;
la figure 7 est une vue schématique en coupe d'un autre exemple d'une diode utile à la compréhension de l'invention; et
la figure 8 est une vue partielle en coupe illustrant une variante de réalisation d'une diode.

### Description détaillée

De mêmes éléments ont été désignés par de mêmes références aux différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position absolue, tels que les termes "haut", "bas", "gauche", "droite", etc., ou relative, tels que les termes "dessus", "dessous", "supérieur", "inférieur", etc., ou à des qualificatifs d'orientation, tels que le terme "vertical", etc., il est fait référence à l'orientation de l'élément concerné dans les figures. Sauf précision contraire, l'expression "de l'ordre de" signifie à 10 % près, de préférence à 5 % près.

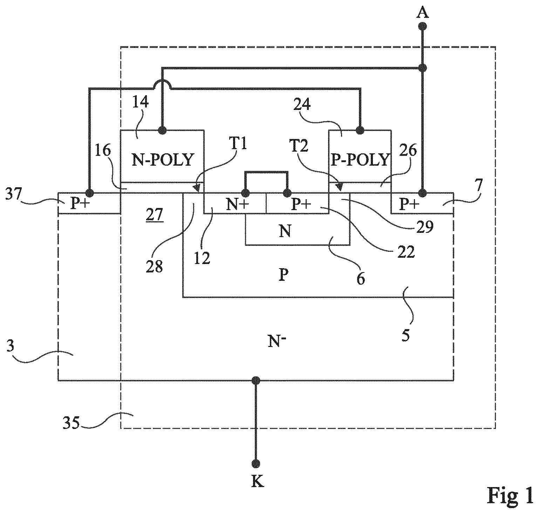

L'inventeur a analysé le fonctionnement d'une diode du type de la diode illustrée en figure 1.

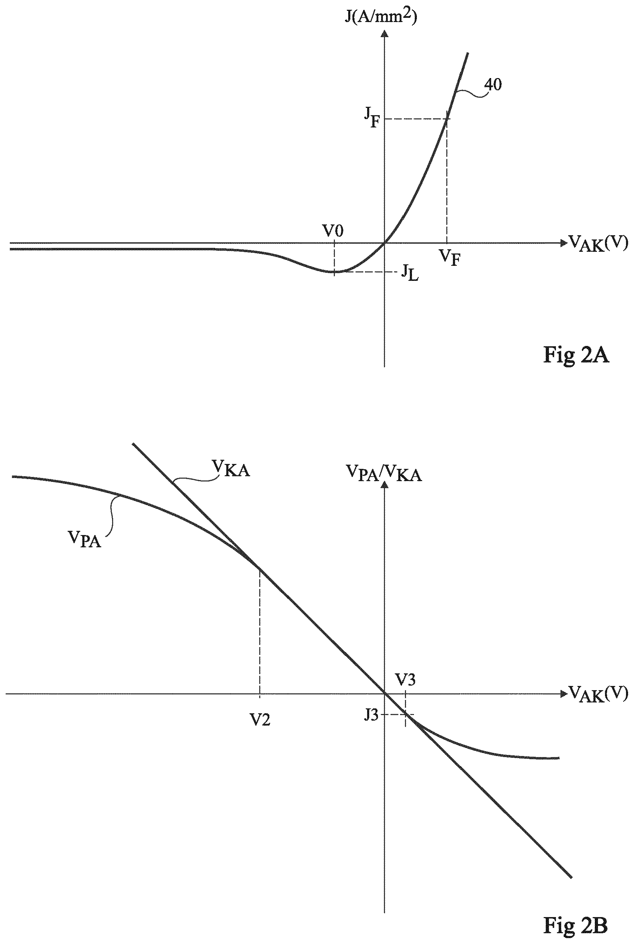

La figure 2A est une courbe 40 qui représente schématiquement la densité de courant J en A/mm² dans la diode 1 de la figure 1 en fonction de la tension V_{AK} appliquée entre l'anode A et la cathode K.

Chacun des transistors T1 et T2 présente une conductance non nulle lorsque la tension entre sa grille et sa source est nulle, bien que cette tension soit inférieure à la valeur permettant la formation d'un canal pleinement conducteur. Ainsi, ces transistors sont à conduction en dessous du seuil (en anglais "subthreshold conduction") à tension nulle. Pour cela les isolants 16 et 26 sous les grilles 14 et 24 sont minces (nanométriques) et les dopages des grilles et des régions de formation de canal 28 et 29 des transistors sont choisis de façon appropriée. A titre d'exemple, la région de formation de canal 28 peut être dopée de 5*10¹⁶ à 5*10¹⁷ atomes/cm³. La région de formation de canal 29 peut être dopée de 10¹⁷ à 5*10¹⁷ atomes/cm³. La grille 14 peut être dopée de plus de 5*10¹⁸ atomes/cm³. La grille 24 peut être dopée de plus de 5*10¹⁸ atomes/cm³. Les isolants 16 et 26 peuvent être en oxyde de silicium et avoir des épaisseurs inférieures à 10 nm.

Lorsque la tension V_{AK} initialement nulle devient de plus en plus négative, le courant inverse ou courant de fuite commence par augmenter du fait de la conductance initiale des transistors T1 et T2. Plus la tension est négative, d'une part plus le potentiel de la grille 24 connectée à la structure de commande 37 augmente par rapport au potentiel du caisson 6 et de la zone 22 et bloque le transistor T2 à canal P, et d'autre part plus le potentiel de la grille 14 connectée à l'anode diminue par rapport au potentiel de la zone 12 et bloque le transistor T1 à canal N. Le courant inverse finit par devenir négligeable. La densité de courant de fuite atteint une valeur maximum J_{L} lorsque la tension V_{AK} a une valeur négative V0.

Lorsque la tension V_{AK} initialement nulle devient de plus en plus positive, les potentiels présents sur les grilles des transistors T1 et T2 initialement légèrement passants rendent ces transistors de plus en plus passants. Lorsque la densité de courant atteint une valeur nominale J_{F}, la chute de tension correspond à la chute de tension directe V_{F} de la diode. Du fait du fonctionnement des transistors T1 et T2, la diode 1 a une chute de tension directe V_{F} faible pour un courant nominal de densité J_{F} important. Cette chute de tension directe est par exemple inférieure à 0,2 V lorsque la densité de courant nominal J_{F} est de l'ordre de 0,5 A/mm².

Il se trouve que la valeur maximum J_{L} de densité de courant de fuite et la valeur de la chute de tension directe V_{F} sont liées. Ainsi, une diode ayant une faible chute de tension directe V_{F} a un courant de fuite élevé dans le sens inverse. On cherche à diminuer la chute de tension directe V_{F} sans augmenter la valeur maximum J_{L}, ou à réduire la valeur maximum J_{L} de fuite sans augmenter la chute de tension directe V_{F}.

La figure 2B est une courbe illustrant la tension V_{PA} entre la zone 37 et l'anode A et la tension V_{KA} entre cathode et anode, en fonction de la tension V_{AK} entre anode et cathode. Lorsque les tensions V_{PA} et V_{KA} sont égales, la zone 37 et la cathode sont au même potentiel. La tension V_{PA} correspond à la tension supportée par l'isolant de la grille 24 du transistor T2.

La jonction P-N entre la zone 37 dopée de type P et le substrat 3 a une conductance non nulle qui permet de charger ou décharger la grille 24 du transistor T2 lorsque la tension V_{AK} varie. Le potentiel de la zone 37 est ainsi maintenu égal au potentiel des parties du substrat 3 environnant la zone 37. C'est pourquoi la zone 37 constitue une sonde de potentiel.

Lorsque la tension V_{AK} initialement nulle commence à devenir négative, la chute de tension entre l'anode et la cathode se produit essentiellement dans les transistors T1 et T2. Le potentiel de la sonde 37 est donc égal au potentiel de la cathode.

Lorsque la tension V_{AK} devient plus négative qu'une tension négative V2 de l'ordre de -0,2 à -5 V, une zone déplétée s'étendant sous la grille 14 dans la région 27 se prolonge sous la sonde 37. Une partie de la chute de tension entre anode et cathode se trouve entre le bas et le haut de cette zone déplétée. Plus la tension V_{AK} est négative, plus la zone déplétée s'étend verticalement et supporte l'essentiel de la chute de tension. Or, le potentiel de la sonde 37 reste proche du potentiel de la partie du substrat située immédiatement sous la grille 14. La chute de tension entre l'anode et la sonde 37 reste limitée et la tension V_{PA} reste supportable par le mince isolant 26 de la grille 24 du transistor T2.

Lorsque la tension V_{AK} initialement nulle augmente positivement, l'essentiel de la chute de tension entre anode et cathode se produit dans les transistors T1 et T2 tant que la densité de courant est inférieure à une valeur J3 comprise par exemple entre 0,1 et 1 A/mm2, correspondant à une tension V3. Lorsque la tension entre anode et cathode est supérieure à la tension V3, le substrat 3 oppose une résistance au passage du courant dans une partie située sous la sonde 37. Ainsi, le potentiel de la sonde 37 est plus élevé que le potentiel de la cathode. Le transistor T2 est moins passant que si le potentiel de la sonde 37 restait égal au potentiel de cathode et la chute de tension directe V_{F} de la diode est donc plus importante.

Or, comme on l'a indiqué précédemment, on cherche à réduire cette chute de tension directe V_{F} - sans augmenter la valeur maximum J_{L} de densité de courant de fuite.

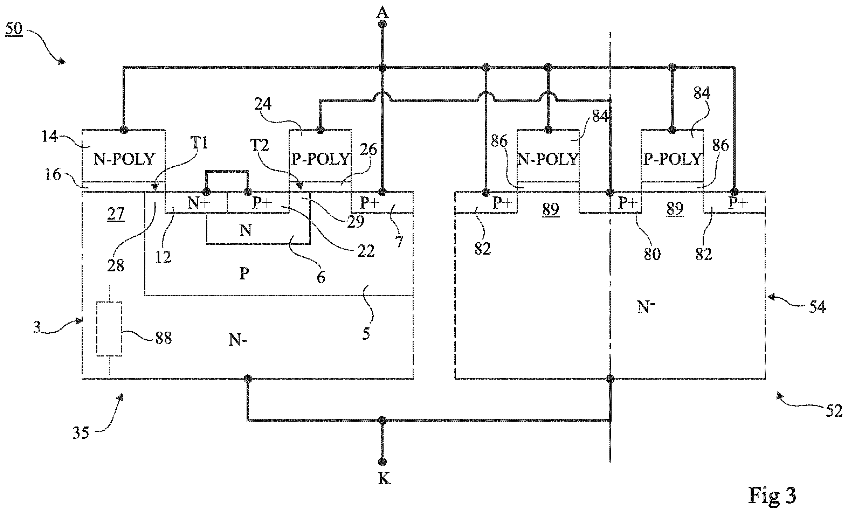

La figure 3 est une vue schématique en coupe d'une diode 50. La diode 50 comprend, à gauche dans la figure, une structure de conduction 35 identique à la structure de conduction 35 de la figure 1 dont les éléments sont désignés par de mêmes références. La diode 50 comprend en outre une structure de commande 52, à droite dans la figure.

La structure de conduction 35 est formée dans et sur une portion 3 d'un substrat semiconducteur dopé de type N, par exemple du silicium. La structure de commande 52 est formée dans et sur une portion 54 de substrat semiconducteur. Les portions 3 et 54 peuvent être des portions distinctes d'un même substrat ou des portions de deux substrats séparés. Chaque portion 3, 54 a sa face inférieure couplée à la cathode K de la diode.

Dans la structure de commande 52, la partie supérieure de la portion de substrat 54 contient des zones dopées 80 et 82 de type P. La zone dopée 82 entoure la zone dopée 80. Une grille 84 annulaire s'étend sur un isolant 86 sur la surface située entre les zones dopées 80 et 82. La grille 84 est en silicium polycristallin dopé du type N. La grille 84 et la zone dopée 82 sont couplées à l'anode A. La zone dopée 80 est couplée à la grille 24 du transistor T2.

La jonction P-N entre la zone dopée 80 et le substrat a une conductance non nulle. La zone dopée 80 constitue ainsi une sonde de potentiel qui détermine le potentiel de la grille 24.

Lorsqu'un courant circule d'anode à cathode dans la diode, une tension V_{AK} positive apparait entre l'anode et la cathode. La jonction P-N entre la zone dopée 82 et la portion de substrat 54 limite le courant circulant dans la portion de substrat 54. La structure de conduction 35 conduit plus de courant que la structure de commande 52. Or, la portion de substrat 3 de la structure de conduction 35 et la portion de substrat 54 de la structure de commande 52 sont distinctes, et la plus grande partie du courant issu de l'anode rejoint la cathode en circulant dans la structure de conduction 35 sans cheminer dans la structure de commande 52 qui commande la grille du transistor T2.

Contrairement à la sonde 37 de la diode 1 de la figure 1, la sonde 80 n'est pas située dans une région destinée au passage du courant. Le passage du courant par la région du substrat 3 située sous la zone de drain 22 du transistor T1 oppose une résistance 88 qui n'est pas située sous la grille 84 de la structure de commande ou sous la sonde 80. La densité de courant dans les parties du substrat situées sous la sonde est faible, par exemple inférieure à 10 % de la densité de courant dans les parties de substrat 3 correspondant à la résistance 88. De ce fait, le potentiel de la sonde 80 reste de l'ordre du potentiel de la cathode K. Ainsi, la chute de tension dans le transistor T2 commandé par la sonde 80 est plus faible que si ce transistor était commandé par une sonde du type de la sonde 37 de la diode 1 de la figure 1. Le fonctionnement du transistor T2 de la diode 50 est donc amélioré par rapport au fonctionnement du transistor T2 de la diode 1. De ce fait, la chute de tension directe de la diode 50 est plus faible que la chute de tension directe de la diode 1.

Lorsqu'une tension V_{AK} négative est appliquée, le potentiel de la sonde 80 reste proche du potentiel de la cathode K tant que la tension V ne dépasse pas une tension négative de 0,2 à 5 V. Le courant de fuite est alors similaire dans la diode 50 et dans la diode 1 de la figure 1. Par contre, la chute de tension provoquée par un courant dans le sens direct peut être beaucoup plus faible dans la diode 50 que dans la diode 1.

Lorsque la tension V_{AK} devient plus négative que la tension V2 (voir figure 2B), le fonctionnement de la sonde 80 est similaire au fonctionnement de la sonde 37 de la diode 1. Une zone déplétée présente dans une région 89 du substrat 54 située sous la grille 84 se prolonge sous la sonde et s'étend d'autant plus vers le bas que la tension V est négative. La majeure partie de la tension V se retrouve entre le bas et le haut de cette zone déplétée. La sonde de potentiel est portée au potentiel de la partie du substrat située immédiatement au-dessous de la grille. De ce fait, la tension supportée par l'isolant 26 est compatible avec une épaisseur faible d'isolant. Le potentiel de la sonde 80 est déterminé principalement par les dopages de la région 89 du substrat 54 et par la configuration de la grille 84 et des zones 80 et 82, en particulier par la distance entre les zones 80 et 82, c'est-à-dire par la dimension dans le sens de la longueur de la grille 84.

A titre d'exemple, la tension entre la sonde 80 et l'anode est inférieure à 5 V lorsque la tension V_{AK} entre anode et cathode est négative de 100 V. A titre d'exemple, la distance entre les zones 80 et 82 est comprise entre 0,3 et 1 µm. L'isolant de grille 86 peut avoir une épaisseur inférieure à 10 nm. A titre d'exemple, la région 89 du substrat est dopée de 10¹⁶ à 2*10¹⁷ atomes/cm³.

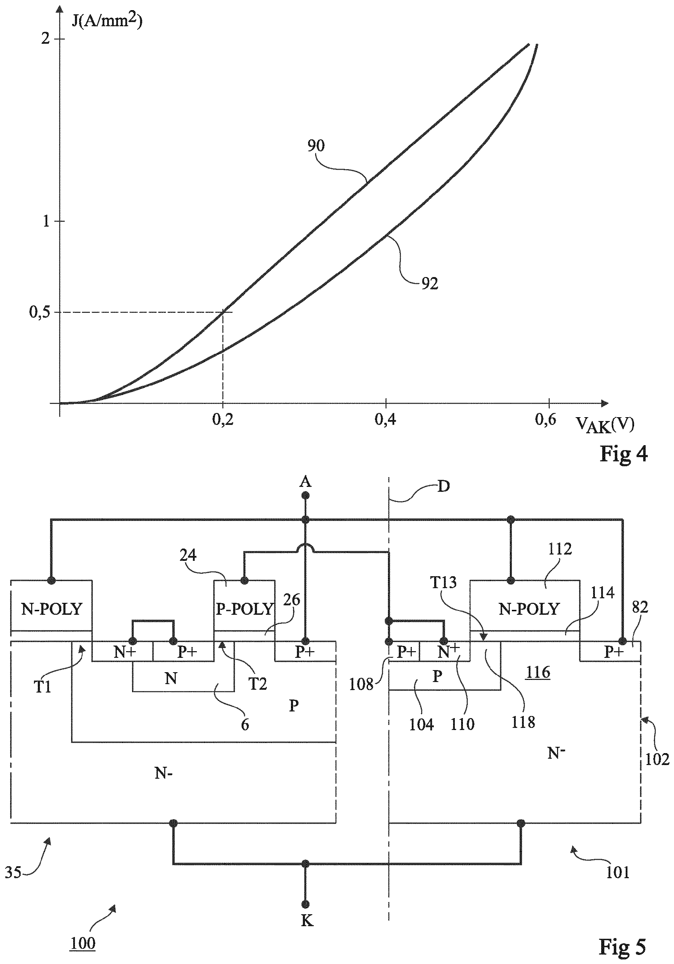

La figure 4 illustre la densité de courant dans deux diodes en fonction de la tension V_{AK} appliquée entre anode et cathode. La courbe 90 correspond à une diode selon l'exemple illustré en figure 3. La courbe 92 correspond à une diode du type de la diode 1 de la figure 1. Les deux diodes ont des densités de courant de fuite identiques (non représentées). Pour une tension donnée, la densité de courant dans la diode 50 est plus élevée que la densité de courant dans la diode 1. Par exemple, pour une chute de tension de 0,2 V, la densité de courant augmente de plus de 70 %. Pour une densité de courant de 0,5 A/mm2, la chute de tension est diminuée de plus de 25 %.

La figure 5 est une vue partielle en coupe illustrant une variante de réalisation d'une diode 100. La diode 100 correspond à la diode 50 de la figure 3 dans laquelle la structure de commande 52 a été remplacée par une structure de commande 101. Seule une demi-coupe de la structure de commande 101 est représentée, cette structure présentant une symétrie de révolution par rapport à un axe vertical D.

La structure de commande 101 est formée dans et sur une portion de substrat semiconducteur 102, par exemple en silicium dopé de type N.

La portion 102 contient un caisson 104 dopé de type P centré sur l'axe D et une zone dopée de type P 82 annulaire. Le caisson 104 comprend une zone 108 dopée de type P plus dopée que le caisson et centrée sur l'axe D. Une zone 110 dopée de type N en partie supérieure du caisson 104 forme un anneau en contact avec la zone 108. Une grille 112 annulaire disposée sur un isolant 114 recouvre les parties du substrat et du caisson situées entre la zone 110 et la zone 82. La grille 112 est en silicium polycristallin dopé du type N.

On a ainsi obtenu un transistor T13 dont la source correspond à la zone 110, le drain correspond à une partie 116 du substrat, et la région de formation de canal correspond à une partie 118 du caisson 110. On note que la grille 112 recouvre la région de formation de canal 118 et se prolonge au-dessus du substrat jusqu'à la limite de la zone 82.

La zone 82 et la grille 112 sont couplées à l'anode A de la diode. Les zones 108 et 110 sont couplées ensemble à la grille 24 du transistor T2 de la structure de conduction 35.

La portion de la grille 112 dopée de type N surmontant le substrat de la structure 101 joue le même rôle que la grille 84 de la structure de commande 52 de la figure 2. La zone 108 dopée P joue le même rôle que la sonde 80 de la structure de commande 52. La structure de commande 101 correspond à la structure de commande 52 dans laquelle la jonction P-N couplant la zone dopée 80 au substrat a été remplacée par le transistor T13 couplant la zone dopée 108 au substrat. Le transistor T13 est à conduction sous le seuil à tension nulle.

Lorsque la tension appliquée aux bornes de la diode varie, des charges circulent dans la jonction P-N entre la sonde 80 et le substrat pour charger ou décharger la capacité de grille du transistor T2 de la structure 52. La conductance entre drain et source du transistor T13 est plus élevée que la conductance de la jonction P-N entre la sonde 80 et le substrat de la diode 50 de la figure 3. De ce fait, la diode 100 a des temps de réaction améliorés.

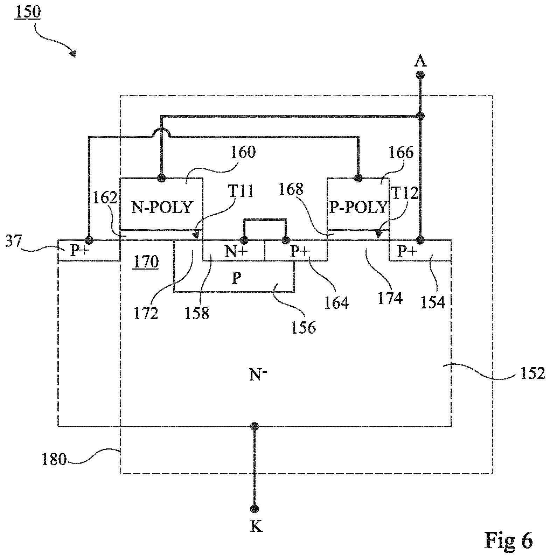

La figure 6 est une vue en coupe illustrant un mode de réalisation d'une diode 150 comprenant une structure de conduction différente des structures de conduction des figures 1, 3 et 5 et de la structure de commande 37 décrite en relation avec la figure 1.

La diode 150 comprend une portion d'un substrat 152 dopé de type N couplée en partie inférieure à la cathode K de la diode. La partie supérieure du substrat contient une zone dopée 154 dopée de type P et un caisson 156 dopé de type P. En partie supérieure du caisson 156, se trouve une zone 158 plus fortement dopée de type N que le substrat. Une grille 160 en silicium polycristallin dopé de type N sur un isolant 162 recouvre une partie du caisson P 156 située entre la zone N 158 et le substrat 152, et se prolonge au-dessus du substrat 152. Une zone 164 plus fortement dopée de type P que le caisson 156 est située en partie supérieure du substrat, à cheval sur le caisson P 156 et en contact avec la zone N 158. Une grille 166 en silicium polycristallin dopé de type P s'étend sur un isolant 168 et recouvre une partie du substrat située entre les zones 154 et 164.

On a obtenu un transistor MOS vertical T11 à canal N dont la source correspond à la zone 158, le drain à une partie 170 du substrat 152 et la région de formation de canal à une partie supérieure 172 du caisson P 156.

On a également obtenu un transistor MOS T12 à canal P dont la source correspond à la zone 164, le drain à la zone 154 et la zone de formation de canal à une partie 174 du substrat 152.

Les zones de source 158 et 164 des transistors T11 et T12 sont connectées entre elles. La grille 160 du transistor T11 et la zone de drain 154 du transistor T12 sont reliées à l'anode A de la diode.

Les transistors T11 et T12 sont à conduction sous le seuil à tension nulle. L'ensemble constitué par les transistors T11 et T12 ainsi connectés entre la cathode et l'anode de la diode constitue une structure de conduction 180. Un courant principal peut cheminer, à travers des transistors T12 et T11, selon le même trajet que dans les transistors T1 et T2 de la structure de conduction 35 de la figure 1.

Une zone 37 dopée de type P est située en partie supérieure du substrat 152 et s'étend à partir de la limite de la grille 160 du transistor T11 en s'éloignant de la partie du substrat recouverte par cette grille. La zone 37 est reliée à la grille 166 du transistor T12 et correspond à une structure de commande qui fixe le potentiel de la grille 166.

Le fonctionnement de la diode 150 est similaire à celui de la diode 1 de la figure 1. En effet, les transistors T11 et T12 de la diode 150 jouent le rôle respectif des transistors T1 et T2 de la diode 1 et la structure de commande 37 correspond à une sonde de potentiel dont le fonctionnement est identique à celui de la sonde de potentiel 37 de la diode 1.

Selon un avantage, les éléments de la diode 150 situés en partie supérieure du substrat 152 ont une disposition particulièrement simple et peuvent être obtenus en un nombre réduit d'étapes. En particulier, le niveau de dopage de la zone de formation de canal 174 du transistor T12 ne résulte pas d'une superposition de plusieurs étapes de dopage de types différents. De ce fait, le niveau de dopage souhaité est plus simple à obtenir pour la zone 174 que pour la zone de formation de canal 29 du transistor T2 de la figure 1.

A titre d'exemple, la région de formation de canal 172 peut être dopée de 5*10¹⁶ à 5*10¹⁷ atomes/cm³. La région de formation de canal 174 peut être dopée de 10¹⁶ à 5*10¹⁷ atomes/cm³. La grille 160 peut être dopée de 5*10¹⁸ à 5*10²⁰ atomes/cm³. La grille 166 peut être dopée de 5*10¹⁸ à 5*10²⁰ atomes/cm³. Les isolants de grille 162 et 168 peuvent avoir des épaisseurs inférieures à 10 nm.

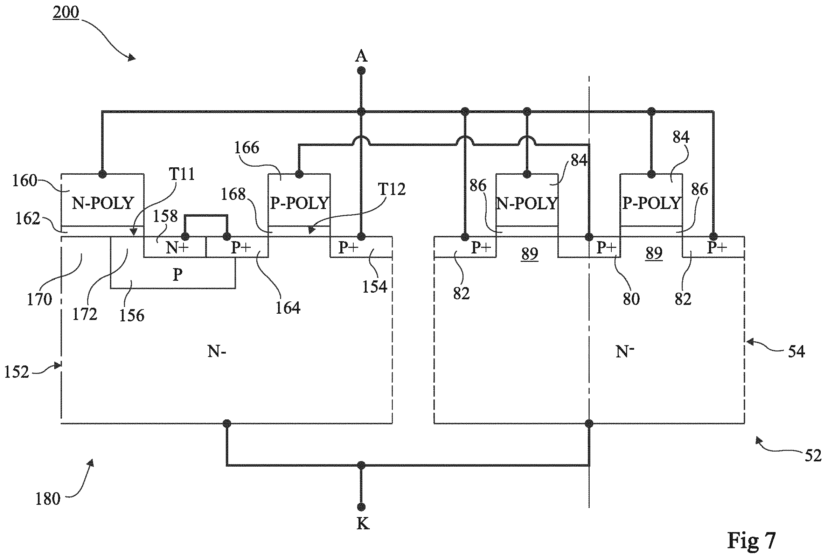

La figure 7 est une vue schématique en coupe d'une autre diode 200. La diode 200 correspond à une combinaison entre la structure de conduction 180 décrite en relation avec la figure 6 et la structure de commande 52 décrite en relation avec la figure 3 et de mêmes éléments y sont désignées par des mêmes références.

Dans la structure de conduction 180 située en partie gauche de la figure, on retrouve les transistors T11 et T12 connectés en série entre la cathode et l'anode de la diode. Dans la structure de commande 52, on retrouve la zone dopée 82 et la grille 84 connectées à l'anode de la diode et la sonde 80. La sonde 80 est couplée à la grille 166 du transistor T2.

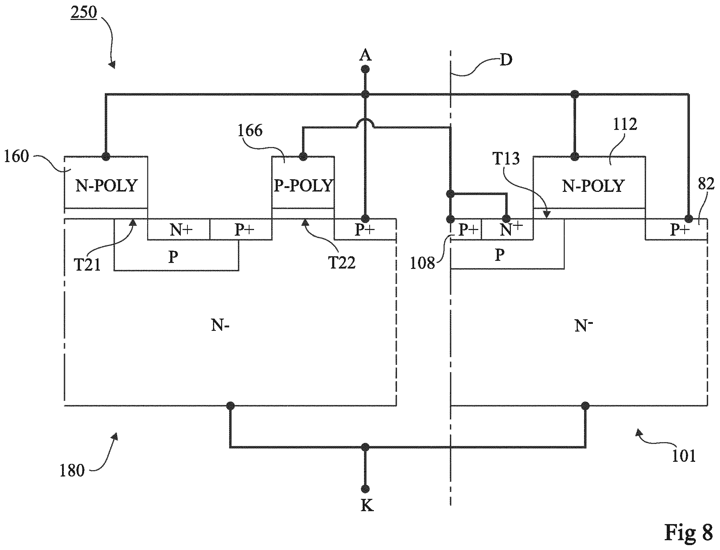

La figure 8 est une vue partielle en coupe illustrant une variante de réalisation d'une diode 250 combinant la structure de conduction 180 décrite en relation avec la figure 6 à la structure de commande 101 décrite en relation avec la figure 5.

Dans la structure de commande 101 à droite sur la figure, on retrouve la grille 112 et la zone dopée 82 connectées à l'anode de la diode, et la zone de sonde 108. La zone de sonde 108 est reliée à la grille 166 du transistor T12.

Des modes de réalisation particuliers ont été décrits. Diverses variantes et modifications apparaîtront à l'homme de l'art. En particulier, dans les modes de réalisation décrits, les diodes sont formées dans et sur des substrats dopés du type N, la cathode étant l'électrode inférieure et l'anode étant l'électrode supérieure. D'autres modes de réalisation sont possibles, dans lesquels le substrat est dopé du type P, et, par rapport aux modes de réalisation décrits précédemment, la cathode K et l'anode A sont inversées ainsi que les types N et P de conductivité.

En outre, les modes de réalisation de diodes décrits précédemment comprennent une structure de commande couplée à une seule structure de conduction (35 ou 180). D'autres modes de réalisation sont possibles comprenant une structure de commande couplée à plusieurs structures de conduction connectées en parallèle entre l'anode et la cathode de la diode. En particulier, dans un exemple utile à la compréhension de l'invention, la structure de commande 101 de la figure 5 peut être couplée simultanément à un plus grand nombre de structures de conduction qu'une sonde de potentiel 80 d'une structure de commande 52 de la figure 3. D'autres modes de réalisation sont également possibles comportant plusieurs structures de commande.

De plus, dans les modes de réalisation décrits précédemment, des structures de commande comprennent des éléments de révolution selon un axe D passant par une sonde de potentiel. Dans d'autres modes de réalisation, ces éléments peuvent avoir des formes différentes et peuvent entourer la sonde totalement ou partiellement.

De même, on pourra considérer que les structures de conduction représentées ne représentent que des demi-coupes de structures annulaires.

## Revendications

1. Diode comprenant :
une portion de substrat semiconducteur (152) dopé d'un premier type de conductivité, entre une électrode supérieure (A) et une électrode inférieure (K) ;
un premier transistor vertical (T11) à canal du premier type de conductivité, dont la grille (160) est dopée du premier type de conductivité et couplée à l'électrode supérieure, le premier transistor ayant une zone de source (158) incluse dans un caisson (156) dopé d'un deuxième type de conductivité, le premier transistor ayant une région de formation de canal (172) située dans ledit caisson ;
un deuxième transistor (T12) à canal du deuxième type de conductivité ayant une grille (166) dopée du deuxième type de conductivité, les premier et deuxième transistors étant connectés en série entre les électrodes; et
une zone de sonde (37) dopée du deuxième type de conductivité, qui s'étend à partir d'une partie (170) du substrat recouverte par la grille du premier transistor, la zone de sonde étant couplée à la grille du deuxième transistor;
la diode étant **caractérisée en ce que**
la région de formation de canal (174) du deuxième transistor (T12) est située hors du caisson et correspond à une partie supérieure du substrat,
et que une zone (164) de source du deuxième transistor est située en partie supérieure du substrat, à cheval sur ledit caisson (156).

2. Diode selon la revendication 1, dans laquelle chacune des grilles (160, 166) est associée à un isolant de grille d'épaisseur inférieure à 10 nm.

3. Diode selon la revendication 1 ou 2, dans laquelle les premier (T11) et deuxième (T12) transistors sont à fonctionnement sous le seuil à tension nulle.

4. Diode selon l'une quelconque des revendications 1 à 3, dans laquelle la région de formation de canal (172) du premier transistor (T11) est dopée de 5*10¹⁶ à 5*10¹⁷ atomes/cm³.

5. Diode selon l'une quelconque des revendications 1 à 4, dans laquelle la région de formation de canal (174) du deuxième transistor (T12) est dopée de 10¹⁶ à 5*10¹⁷ atomes/cm³.

6. Pont redresseur à diodes comprenant une diode selon l'une quelconque des revendications 1 à 5.

7. Convertisseur de puissance continu-continu comprenant une diode selon l'une quelconque des revendications 1 à 5.

## Patentansprüche

1. Eine Diode, die Folgendes aufweist:
einen Halbleitersubstratabschnitt (152) eines ersten Leitfähigkeitstyps zwischen einer oberen Elektrode (A) und einer unteren Elektrode (K);
einen ersten vertikalen Transistor (T11) mit einem Kanal vom ersten Leitfähigkeitstyp, dessen Gate (160) vom ersten Leitfähigkeitstyp dotiert und mit der oberen Elektrode gekoppelt ist, wobei der erste Transistor einen Source-Bereich (158) aufweist, der in einer dotierten Wanne (156) eines zweiten Leitfähigkeitstyps enthalten ist, wobei der erste Transistor einen kanalbildenden Bereich (172) aufweist, der in der Wanne angeordnet ist;
einen zweiten Transistor (T12) mit einem Kanal eines zweiten Leitfähigkeitstyps, der ein dotiertes Gate (166) vom zweiten Leitfähigkeitstyp aufweist, wobei der erste und der zweite Transistor zwischen den Elektroden in Reihe geschaltet sind; und
eine dotierte Sondenfläche (37) vom zweiten Leitfähigkeitstyp, die sich von einem Abschnitt (170) des Substrats aus erstreckt, der von dem Gate des ersten Transistors bedeckt ist, wobei die Sondenfläche mit dem Gate des zweiten Transistors gekoppelt ist;
wobei die Diode **dadurch gekennzeichnet ist, dass**:
der kanalbildende Bereich (174) des zweiten Transistors (T12) außerhalb der Wanne liegt und einem oberen Teil des Substrats entspricht,
und dass sich ein Source-Bereich (164) des zweiten Transistors in einem oberen Teil des Substrats rittlings auf der besagten Wanne befindet.

2. Diode nach Anspruch 1, wobei jedes der Gates (160, 166) mit einem Gateisolator mit einer Dicke von weniger als 10 nm verbunden ist.

3. Diode nach Anspruch 1 oder 2, wobei der erste (T11) und der zweite (T12) Transistor einen Unterschwellenbetrieb bei einer Spannung von null Volt haben.

4. Diode nach einem der Ansprüche 1 bis 3, wobei der kanalbildende Bereich (172) des ersten Transistors (T11) zwischen 5*10¹⁶ und 5*10¹⁷ Atomen/cm³ dotiert ist.

5. Diode nach einem der Ansprüche 1 bis 4, wobei der kanalbildende Bereich (174) des zweiten Transistors (T12) zwischen 10¹⁶ und 5*10¹⁷ Atomen/cm³ dotiert ist.

6. Eine Gleichrichterbrücke mit Dioden, die die Diode nach einem der Ansprüche 1 bis 5 aufweist.

7. Ein Gleichspannungswandler, der die Diode nach einem der Ansprüche 1 bis 5 aufweist.

## Claims

1. A diode comprising:
a semiconductor substrate portion (152) of a first conductivity type, between an upper electrode (A) and a lower electrode (K);
a first vertical transistor (T11) having a channel of the first conductivity type, the gate (160) of which is doped of the first conductivity type and coupled to the upper electrode, the first transistor having a source area (158) comprised in a doped well (156) of a second conductivity type, the first transistor having a channel-forming region (172) located in said well;
a second transistor (T12) with a channel of a second conductivity type having a doped gate (166) of the second conductivity type, the first and second transistors being series-connected between the electrodes; and
a doped probe area (37) of the second conductivity type, extending from a portion (170) of the substrate covered by the gate of the first transistor, the probe area being coupled to the gate of the second transistor;
the diode being **characterized in that**:
the channel-forming region (174) of the second transistor (T12) is located outside of the well and corresponds to an upper portion of the substrate,
and that a source area (164) of the second transistor is located in an upper portion of the substrate, astride said well.

2. The diode of claim 1, wherein each of the gates (160, 166) is associated with a gate insulator having a thickness smaller than 10 nm.

3. The diode of claims 1 or 2, wherein the first (T11) and second (T12) transistors have a subthreshold operation at a zero voltage.

4. The diode of any of claims 1 to 3, wherein the channel-forming region (172) of the first transistor (T11) is doped between 5*10¹⁶ and 5*10¹⁷ atoms/cm³.

5. The diode of any of claims 1 to 4, wherein the channel-forming region (174) of the second transistor (T12) is doped between 10¹⁶ and 5*10¹⁷ atoms/cm³.

6. A rectifying bridge with diodes, comprising the diode of any of claims 1 to 5.

7. A DC-DC power converter comprising the diode of any of claims 1 to 5.
